# EUROPEAN PATENT APPLICATION

(11) **EP 4 471 805 A1**
(43) Date of publication of application: **04.12.2024**
(21) Application number: 23747196.6
(22) Date of filing: 05.01.2023
(51) Int. Cl.: G21D 3/04, G21D 3/00, G06F 30/20

(54) **METHOD FOR ANALYZING SEVERE ACCIDENT AT NUCLEAR POWER PLANT BY USING MODULAR ANALYSIS CODE**

(30) Priority: 26.01.2022 KR 20220011339
(71) Applicant: Korea Hydro & Nuclear Power Co., Ltd, Gyeongju-si, Gyeongsangbuk-do 38120 (KR)
(72) Inventor: PARK, Jae Hwan, Daejeon 34101 (KR); CHOI, Yu Jung, Daejeon 34101 (KR); KIM, Chang Hyun, Daejeon 34101 (KR)
(74) Representative: Habermann, Hruschka & Schnabel
(86) International application number: PCT/KR2023/000205
(87) International publication number: WO 2023/146153

(57) **Abstract**

The present invention relates to a method for analyzing a severe accident at a nuclear power plant by using a modular analysis code, comprising the step of: receiving the input of a nuclear power plant to be analyzed and an accident sequence; selecting, from a modular analysis code, an individual module for analyzing a severe accident that is triggered by the accident sequence; setting an accident simulation variable for simulating the severe accident from a nuclear power plant input model; determining whether the accident simulation variable is valid; and, if determined to be valid, analyzing the severe accident through the modular analysis code by using the accident simulation variable, wherein the individual module of the modular analysis code includes: a master module; a first module for analyzing in-core phenomena in the event of a severe accident; a second module for analyzing ex-core phenomena in the event of a severe accident; and a third module for analyzing behaviors of fission products in the event of a severe accident by using in-core thermal-hydraulic information and ex-core thermal-hydraulic information calculated by the first module and the second module, and information movement among the first module, the second module, and the third module is achieved through the master module.

## Description

### Technical Field

The present disclosure relates to a severe accident analysis method for a nuclear power plant using a modular analysis code.

This study was conducted with support from the Ministry of Trade, Industry and Energy (MOTIE) and the Korea Institute of Energy Technology Evaluation and Planning (KETEP). (No. 20193110100050)

### Background Art

A thermal-hydraulic safety analysis code for simulating an accident phenomenon that may occur in a nuclear power plant system is used to simulate a thermal-hydraulic phenomenon that occurs within the system.

It is necessary to analyze a severe accident phenomenon in which a large amount of fission products is released as nuclear fuel coria under high-temperature and high-pressure environmental conditions. In addition, as a reactor vessel is damaged and a reactor core corium is moved to a containment building outside a reactor, a variety of complex and severe accident phenomena may occur.

For this analysis, a new analysis system is required, and in particular, a new method for analysis of a severe accident is required.

### Disclosure

### Technical Problem

Therefore, an object of the present disclosure is to provide a severe accident analysis method for a nuclear power plant using a modular analysis code.

### Technical Solution

The object of the present disclosure is achieved by a severe accident analysis method for a nuclear power plant using a modular analysis code, the severe accident analysis method including: receiving a nuclear power plant as an analysis target and an accident sequence; selecting an individual module for analyzing a severe accident caused by the accident sequence from the modular analysis code; setting an accident simulation variable for simulating the severe accident from a nuclear power plant input model; determining the validity of the accident simulation variable; and analyzing the severe accident through the modular analysis code using the accident simulation variable when the accident simulation variable is determined to be valid, wherein the individual modules of the modular analysis code include a master module; a first module configured to analyze an in-vessel phenomenon at the time of the severe accident; a second module configured to analyze an ex-vessel phenomenon at the time of the severe accident; and a third module configured to analyze a behavior of fission products at the time of the severe accident using in-vessel thermal-hydraulic information and ex-vessel thermal-hydraulic information calculated in the first module and the second module, and information is transferred between the first module, the second module, and the third module through the master module.

The accident simulation variable may include a set value of the accident simulation variable.

The validity determination step may include determining whether the accident simulation variable satisfies (1) an input allowable range, (2) a logical allowable range, and (3) a physical allowable range in the modular analysis code.

The information may include first information required for the first module, the second module, and the third module, and second information generated by the first module, the second module, and the third module, and the information may be stored in the master module, and may be provided from the master module upon a request from the first module, the second module, and the third module.

The information may include thermal-hydraulic information, fission product information, and corium information, the thermal-hydraulic information may be transferred between the first module and the second module through the master module and calculated in association, the thermal-hydraulic information calculated in association may be transferred to the third module through the master module, the fission product information may be transferred from the third module to the master module, and the corium information may be transferred from the first module to the second module through the master module.

The first module may associate a thermal-hydraulic safety analysis code with a reactor core damage module, the thermal-hydraulic safety analysis code may include a nuclear reactor coolant system model, and the reactor core damage module may include a reactor core shape model, a reactor core heating model, a reactor core relocation model, and an in-lower-hemisphere reactor core corium behavior analysis model.

The second module may include a containment building thermal-hydraulic analysis model, a hydrogen combustion model, a steam explosion model, an HPME/DCH model, and a reactor core corium-concrete reaction model.

The third module may include a fission product release model, a fission product transport model, and a fission product removal model.

### Advantageous Effects

According to the present disclosure a severe accident analysis method for a nuclear power plant using a modular analysis code is provided.

### Description of Drawings

FIG. 1 is a flowchart illustrating a severe accident analysis method according to an embodiment of the present disclosure.
FIG. 2 illustrates a configuration of a modular analysis code used in the severe accident analysis method according to the embodiment of the present disclosure.
FIG. 3 illustrates information sharing in the modular analysis code used in the severe accident analysis method according to the embodiment of the present disclosure.

### Mode for Disclosure

The present disclosure relates to a system that can perform a comprehensive evaluation of a severe accident that may occur in a nuclear power plant. More specifically, the present disclosure relates to a system that can evaluate various severe accident scenarios by appropriately applying the performance and characteristics of each module of a severe accident comprehensive analysis code.

Hereinafter, the present disclosure will be described in more detail with reference to the drawings.

Since the attached drawings are only an example illustrated in order to describe the technical idea of the present disclosure in greater detail, the idea of the present disclosure is not limited to the attached drawings. Further, in the attached drawings, sizes, spacings, and the like may be exaggerated compared to reality in order to describe a relationship between respective components.

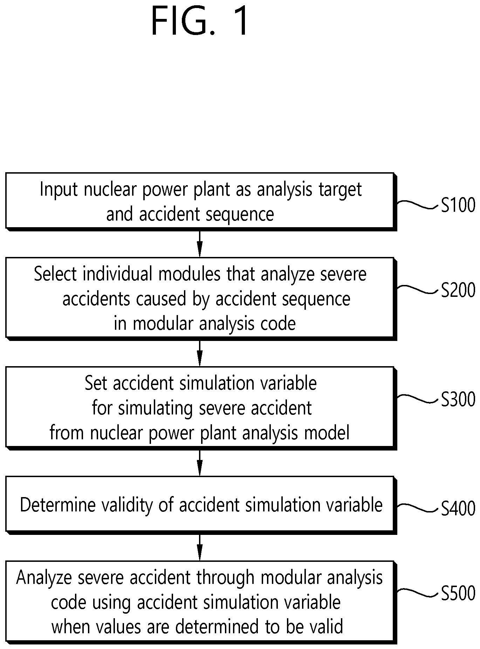

FIG. 1 is a flowchart illustrating a severe accident analysis method according to an embodiment of the present disclosure.

First, a nuclear power plant as an analysis target and an accident sequence are input (S100).

The nuclear power plants as an analysis target include OPR1000 and APR1400, which are domestic pressurized light water reactor type nuclear power plants, but are not limited to. In addition, a nuclear power plant input model (standard input model) of the nuclear power plant as an analysis target is selected.

The accident sequence may be an initial accident that leads to a severe accident. The progress and results of the severe accident may vary depending on a selection of the initial accident, and a selection method for the initial accident can be divided into a deterministic scheme and a probabilistic scheme.

The deterministic scheme is a scheme of selecting an accident sequence that are set to cause a severe accident, and for the accident sequence of the deterministic scheme, five representative accident sequences (large break cooling water loss accident, medium break cooling water loss accident, small break cooling water loss accident, complete water supply loss accident, and power loss accident) can be considered. The probabilistic scheme is a scheme for selecting an accident sequence in comprehensive consideration of design information and mitigation facilities of a nuclear power plant by applying a probabilistic approach. For the selection of the accident sequence, various considerations (nuclear power plant shape information, safety facility, accident mitigation facility, and the like) are appropriately selected and combined for selection of an accident scenario in which a severe accident may occur.

The nuclear power plant as an analysis target and the accident sequence can be randomly selected by a computer or selected and input by the user.

Next, individual modules that analyze severe accidents caused by accident sequence are selected in the modular analysis code (S200).

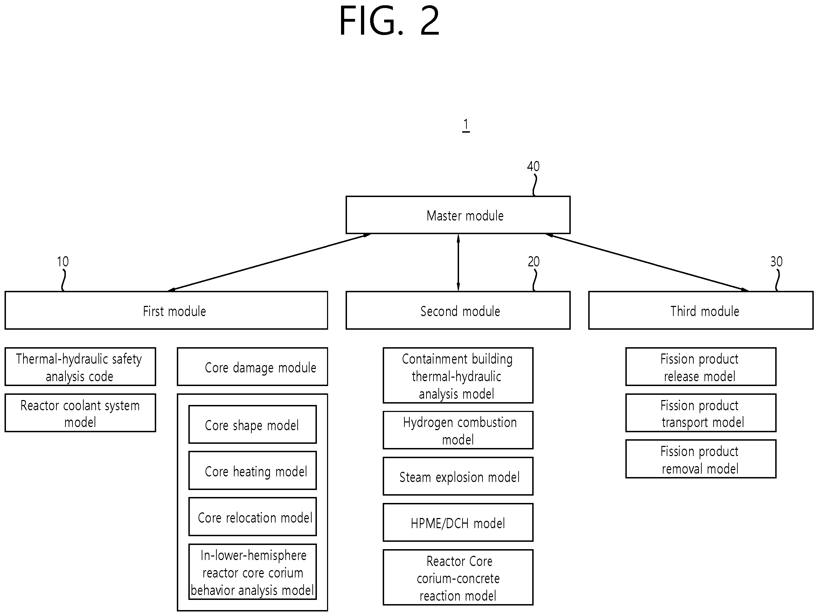

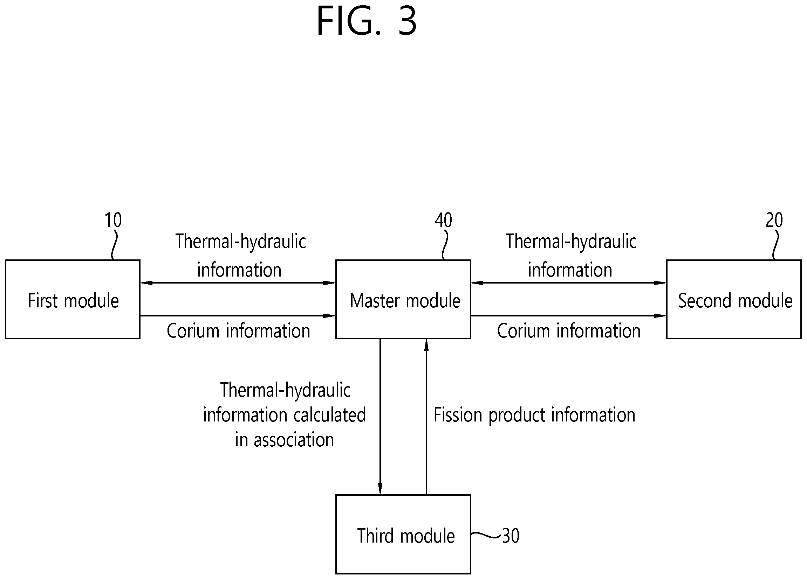

The modular analysis code will be described with reference to FIGS. 2 and 3.

FIG. 2 illustrates a configuration of the modular analysis code that is used in the severe accident analysis method according to an embodiment of the present disclosure, and FIG. 3 illustrates information sharing in the modular analysis code used in the severe accident analysis method according to the embodiment of the present disclosure.

The modular analysis code is configured of a modular structure for each major phenomenon, and has a structure and characteristics capable of effectively analyzing severe accident phenomena, such as an analysis range and characteristics of each module, and comprehensive analysis for a severe accident through association analysis.

A modular analysis code 1 includes a master module 40, a first module 10, a second module 20, and a third module 30.

The first module 10 analyzes an in-vessel phenomenon at the time of a severe accident, the second module 20 analyzes an ex-vessel phenomenon at the time of the severe accident, and the third module 30 analyzes a behavior of fission products at the time of the severe accident is analyzed using in-vessel thermal-hydraulic information and ex-vessel thermal-hydraulic information calculated in the first module 10 and the second module 20. The respective modules 10, 20, 30, and 40 may include a memory that stores information.

Information is transferred between the first module 10, the second module 20, and the third module 30 through the master module 40, as shown in FIG. 2.

Information may include first information required for the first module 10, the second module 20, and the third module 30, and second information generated in the first module 10, the second module 20, and the third module 30.

Information is stored in the master module 40, and is provided from the master module 40 upon a request from the first module 10, the second module 20, and the third module 30.

The information may include thermal-hydraulic (T/H) information, fission product information, and corium information. The thermal-hydraulic information is transferred between the first module 10 and the second module 20 through the master module 40 and calculated in association, the thermal-hydraulic information calculated in association is transferred to the third module 30 through the master module 40, the fission product information is transferred from the third module 30 to the master module 40, and the corium information is transferred from the first module 10 to the second module 20 through the master module 40.

Hereinafter, the respective modules 10, 20, 30, and 40 will be described in detail.

The master module 40 associates analysis data between individual analysis modules, the first module 10 analyzes a thermal-hydraulic phenomenon of a reactor coolant system and simulates a reactor core damage phenomenon, the second module 20 analyzes the thermal-hydraulic phenomenon inside the containment building and analyzes a severe accident phenomenon that may occur inside the containment building, and the third module 30 analyzes a behavior of fission products that are released to the outside when a severe accident occurs.

The master module 40 can store and share all pieces of data so that calculation results of individual modules can be shared between the modules. The master module 40 may collectively store all pieces of data generated as a result of calculation in the memory, and the individual module that requires this may call the necessary data from the memory and use the data for calculation.

The master module 40 introduces an MPI (Message Passing Interface) library, which is widely used in parallel scientific calculations, to synchronize time steps performed by the individual modules so that calculation results in the same time period can be shared. More specifically, pieces of time step information of the respective modules are compared with each other, and a minimum value is designated as the time step and redistributed to each module. Each individual module performs the calculation at a time step given from the master module 40 and then provides the result to the master module 40 back. When calculation results of all analysis modules converge, the calculation results are stored in a storage, but when the calculation results do not converge, the master module 40 adjusts the time step and performs redistribution to each module so that additional calculations can be performed.

The first module 10 also simulates reactor core exposure and heating, cladding oxidation and resultant hydrogen generation, fuel material relocation and flow path blockage, corium pool formation, transport of the corium to the lower hemisphere, a corium behavior in the lower hemisphere and heating of the lower hemisphere, ultimate lower hemisphere integrity evaluation, and release of the corium and coolant into the containment building depending on change in thermal-hydraulic conditions in a primary system and the reactor core as an accident progresses from a normal state.

The first module 10 associates a thermal-hydraulic safety analysis code (SPACE) which performs thermal-hydraulic analysis of the reactor coolant system with a reactor core damage module (COMPASS) which performs reactor core damage phenomenon analysis to simulate a severe accident inside the nuclear reactor. The thermal-hydraulic safety analysis code includes a reactor coolant system model, and the reactor core damage module is configured of a reactor core shape model, a reactor core heating model, a reactor core relocation model, an in-lower-hemisphere reactor core corium behavior analysis model, and the like.

The reactor core shape model can define the reactor core in detail depending on components and constituent materials of the reactor core to simulate not only a normal state of the reactor core but also a reactor core damage behavior with the progress of the accident. The reactor core defined through this calculates the temperature distribution according to the heat transfer correlation equation.

The reactor core heating model simulates a phenomenon in which the reactor core is heated as a coolant in the reactor core decreases. More specifically, the reactor core heating model also calculates heat conduction, thermal convection, and radiative heat transfer in the reactor core, and as a result, simulates swelling and damage of a cladding, fission product emission, cladding oxidation and hydrogen production, a heating behavior of a structure including the control rods, and the like.

The reactor core relocation model also simulates formation of common materials in the fuel rods due to exposure of the fuel rods, a behavior of relocation of the reactor core corium such as relocation of the fuel rods and structures, and change in thermal-hydraulic environment such as blockage of a flow path that may be caused thereby. Further, the reactor core relocation model simulates reactor core corium pool formation due to reactor core corium relocation, expansion of the corium pool to the left, right, and bottom, cooling behavior, transport to the lower hemisphere, or the like.

The in-lower-hemisphere reactor core corium behavior analysis model evaluates formation and cooling of a debris bed in a lower hemisphere of a reactor vessel, formation and cooling of the corium pool, heat transfer from the corium pool to the coolant and an inner wall, and resultant integrity of the lower hemisphere.

The reactor coolant system simulates damage to a pressure boundary in the primary system due to a natural circulation of high-temperature steam inside a reactor system, and simulates a resultant thermal-hydraulic and radiation source term behavior. In addition, accident mitigation such as operator measures and safety injections may be considered for analysis necessary for establishment of a severe accident management procedure.

The second module 20 independently simulates phenomena such as reactor core corium release, containment building pressurization, steam explosion, reactor core corium-concrete reaction, hydrogen combustion, and HPME/DCH which are major severe accident phenomena that may occur inside the containment building during the progress of the severe accident. Further, an engineering safety facility such as a spray or a hydrogen control facility can be selectively applied.

A containment building thermal-hydraulic analysis model 21 calculates a temperature and pressure inside the containment building, for evaluation of the integrity of the containment building, performance of an engineering safety system, device verification range, and device survivability according to the severe accident. Further, the containment building thermal-hydraulic analysis model 21 calculates a concentration and distribution of non-condensable gases, including flammable gases such as hydrogen and carbon monoxide.

A hydrogen combustion model 22 simulates a detailed phenomenon of hydrogen combustion that can occur inside the containment building and analyzes change due to combustion of the hydrogen that is the flammable gas among the non-condensable gases. More specifically, when there is the hydrogen that is the flammable gas, the hydrogen combustion model 22 calculates a combustion start criterion, a combustion rate, a combustion duration, a complete combustion degree, a diffusion flame generation criterion, a diffusion flame combustion rate, or the like, and determines a likelihood of occurrence of flame acceleration and combustion-explosion transition, based on this.

A steam explosion model 23 analyzes a pressure and load of a steam explosion. More specifically, the steam explosion model 23 separately calculates a steam explosion mixing process, steam explosion, and steam explosion propagation phenomenon, and calculates a load on surrounding structures, including the containment building by a pressure wave behavior calculated through this.

An HPME (high pressure corium ejection)/DCH (direct containment heating) model 24 simulates a behavior of the reactor core corium in the reactor cavity when the reactor core corium is released into the reactor cavity immediately after the reactor vessel is damaged due to a reactor core corium accident caused by high pressure. In greater detail, a behavior in which the reactor core corium emitted from the reactor cavity is released to each node constituting the containment building or is blocked and trapped by a surrounding structure is simulated, and chemical change in the corium is also simulated.

The reactor core corium-concrete reaction model 25 simulates floor concrete erosion due to high-temperature corium when the reactor core corium released due to damage to the reactor vessel comes into contact with a floor concrete of a reactor building. Here, an influence on reactor core corium pool formation, heat transfer process, concrete erosion, change in floor shape, gas generation, chemical change in corium and gas, and the like are included. In addition, other accident progression phenomena that may be caused or influenced by a reaction between the reactor core corium and the concrete, that is, a likelihood of the reactor core corium being cooled by a coolant layer in a floor space of the reactor building or a process of forming radionuclide gases or aerosols is additionally analyzed.

The third module 30 simulates release, movement, and removal behaviors for fission products within a reactor vessel, a reactor cooling system, and a containment building at the time of the severe accident. More specifically, a behavior of release of the fission products such as in-fuel-rod gap release, release due to melting of nuclear fuel rods, volatilization release in the reactor cavity, or oxidation release due to explosion, movement between compartments, condensation, evaporation, adsorption, collision, gravitational sedimentation, diffusion and temperature-dependent adhesion to a wall of released fission products, containment building spraying, a removal process using a fan cooler, a water tank or a filter, or the like are simulated.

The fission product release model 31 simulates a fraction of release of the fission products from the reactor core by nuclide type or group depending on a temperature behavior of the nuclear fuel rods according to accident conditions, tracks a movement of the reactor core corium appearing during melting of the nuclear fuel rods into and out of the reactor vessel, and calculate an amount of released fission products. The fission product release model 31 simulates an amount of release of fission products when the reactor core corium is relocated in the reactor cavity and reacts with the concrete.

The fission n product transport model 32 must be able to simulate a phenomenon in which the fission products released from the reactor core corium are transported into the reactor cooling system in the form of gas and aerosol under thermal-hydraulic conditions within the reactor cooling system.

The fission product removal model 33 tracks condensation, evaporation, adsorption, collision, gravitational sedimentation, diffusion and temperature-dependent adhesion to a wall of the fission products, containment building spraying, and an amount of removal during transport using a fan cooler, a water tank, a filter, or the like.

According to the present disclosure, the severe accident phenomena that may occur in the nuclear power plant are greatly divided into the in-vessel phenomenon inside the reactor vessel and the ex-vessel phenomenon outside the reactor vessel, and calculations are performed. In addition, calculation for the behavior of the fission products for analyzing the movement of the fission products generated during the severe accident is performed. The master module 40 collects information data generated during calculation of each phenomenon and shares the information so that the information can be used between each other.

For the in-vessel phenomenon, the thermal-hydraulic phenomenon including the nuclear reactor and the reactor coolant system is calculated through the first module 10. Behaviors of nuclear fuel and reactor core corium melt due to a high temperature during the severe accident are calculated. The nuclear core melt due to the high temperature is moved downward in the reactor and collected in the lower hemisphere. The reactor vessel may be damaged by the high-temperature reactor core corium.

For the ex-vessel phenomenon, a phenomenon occurring inside the reactor building other than the primary system is calculated through the second module 20. The calculation is performed on detailed phenomena such as a behavior of flammable gas, steam explosion, interaction between the reactor core corium and the concrete, and high-pressure ejection of the reactor core corium, which are representative ex-vessel severe accident phenomena. Further, a mitigation facility for a severe accident can be applied, and a hydrogen ignitor that is a representative flammable gas control device, and a passive catalytic hydrogen recombiner or a spray system that is effective in adjusting a temperature and pressure of atmosphere or decontamination of the fission products can be applied.

The fission products generated from nuclear fuel damaged during the severe accident are calculated by the third module 30. Thermal-hydraulic information inside and outside the vessel is calculated and the fission products move according to a flow of liquid or gas.

All pieces of information required for calculation are collectively stored in the master module 40, information required for calculation for each module is called from the master module 40, the calculation is performed, and then, the information is sent back to the master module 40 so that the information is shared with other modules.

The progress of the severe accident can greatly change depending on various environmental factors such as failure of or damage to a device, an operation of the safety facility, and a point in time of application, and countermeasures must be applied appropriately depending on the progress. Similarly, in the severe accident analysis, it is important to select and apply an appropriate analysis model according to an ongoing severe accident phenomenon.

A possible severe accident phenomenon is predicted depending on the input accident sequence, and an appropriate analysis module is selected. For example, behavior analysis and cooling of the reactor core corium inside the nuclear reactor can be performed using only an in-vessel phenomenon analysis module. Here, when the behavior of the fission products in the primary side is to be analyzed, a fission product behavior analysis module may be additionally analyzed. All pieces of association data are transferred through an association module, and calculated results are stored in the association module and converted and output as an output variable, when necessary.

Next, an accident simulation variable for simulating the severe accident is set from a nuclear power plant analysis model (S300).

To simulate the severe accident at the nuclear power plant, variables necessary for simulation of the accident progress are extracted in the nuclear power plant input model (nuclear power plant standard input model), which includes numerous design information such as a shape, environmental conditions, and a safety facility of the nuclear power plant. The accident simulation variable includes a number of variables, including progress from start of the accident and a mitigation method. The extracted accident simulation variable has a set value that is changed so that the required accident progress can be simulated.

In the present disclosure, the 'accident simulation variable' is a variable that is changed in the 'nuclear power plant standard input model' for setting of a situation for causing a severe accident or performing a mitigation method for preventing a severe accident from occurring.

For example, a pipe crack setting variable may be the accident simulation variable when a crack occurs in a specific pipe, the internal coolant is released to the outside, and internal pressure changes.

As another example, a pressure control valve opening/closing setting variable may be an accident simulation variable in a case where the internal pressure is to be decreased when the internal pressure increases rapidly due to overheating caused by damage to the nuclear fuel.

Next, a validity of the accident simulation variable is determined (S400).

Serious accident analysis using the modular analysis code simply requires input of dozens to thousands of variables.

In order for results acquired through analysis of a computational code to have meaningful results, the validity of values of input variables must be confirmed for a determination as to whether or not the values are valid for accident simulation. The validity is determined through a review of an allowable range of the input variables modeled in the modular analysis code, a logical allowable range required for association analysis through association calculation of each variable, a physical allowable range for reviewing physical appropriateness of analysis results accumulated as output at every moment during a detailed phenomenon analysis process, or the like. The values are determined to be valid only when the allowable range of the input variable, the logical allowable range, and the physical allowable range are all satisfied.

In the present disclosure, the 'allowable range of the input variable' is intended to determine whether a temperature of the coolant is within a range of the temperature of the coolant that can be calculated by the modular analysis code in an example of the temperature of the coolant.

In the present disclosure, the 'logical allowable range' is intended to determine whether the variable is within an allowable range required for association analysis through association calculation.

The association calculation refers to a process of calculating a desired value in a model equation with several variables through association calculation of respective input variables in the model equation.

The association analysis refers to analysis in which values calculated during analysis are exchanged at equal time intervals and used for calculations inside the modules so that results of the analysis in the individual modules are associated.

A sum of individual gas fractions must be 100% in an example of a gas fraction, and the logical allowable range is intended to confirm the validity thereof.

In the present disclosure, the 'physical allowable range' is a similar concept to the allowable range of the input variables and relates to a physical variable such as a size. For example, when a value equal to or greater than a settable maximum area (25 pi) is input while a damage area of a pipe with a diameter set to 10 in the 'nuclear power plant standard input model' is being set, this is physically impossible, and therefore, the validity thereof is confirmed. As another example, when space A (height 10) and space B (height 5) where analysis is performed in a computational code are set and a door is built between A and B, a height of the door equal to or greater than 5 is physically inappropriate.

When the values are determined to be valid, the severe accident is analyzed through the modular analysis code using the accident simulation variable (S500).

The severe accident phenomenon and progress are simulated through execution of the modular analysis code using the input file of which the validity has been confirmed.

Calculation results produced through computational analysis are extracted and quantitatively analyzed, and comprehensive analysis for the severe accident progress and a phenomenon that may occur due to this is performed.

After a comprehensive review for the severe accident phenomenon is completed, additional analysis may be performed on the progress and detailed phenomenon of the severe accident at the nuclear power plant by applying mitigation measures or mitigation facilities for securing the integrity of a nuclear reactor building from the severe accident, and the progress and influence of the ongoing accident may be confirmed. In this case, a severe accident mitigation strategy or response facility is selectively selected, an appropriate input is developed, a re-analysis is performed, and analysis results are reviewed.

For example, when concrete erosion due to the reactor core corium occurs during an accident sequence in basic analysis, the concrete erosion can be prevented or delayed through injection of a coolant using an external emergency coolant injection facility. Analysis is performed with corrected inputs in the latest restart file in which variables such as an injection point in time or a flow rate of the coolant have been corrected, so that effective comparative analysis is possible.

The above-described embodiments are examples for describing the present disclosure, and the present disclosure is not limited thereto. Since those skilled in the art to which the present disclosure pertains will be able to implement the present disclosure through various modifications of the embodiments, the technical protection scope of the present disclosure should be determined by the appended claims.

## Claims

1. A severe accident analysis method for a nuclear power plant using a modular analysis code, the severe accident analysis method comprising:
receiving a nuclear power plant as an analysis target and an accident sequence;
selecting an individual module for analyzing a severe accident caused by the accident sequence from the modular analysis code;
setting an accident simulation variable for simulating the severe accident from a nuclear power plant input model;
determining the validity of the accident simulation variable; and
analyzing the severe accident through the modular analysis code using the accident simulation variable when the accident simulation variable is determined to be valid, wherein
the individual modules of the modular analysis code include
a master module;
a first module configured to analyze an in-vessel phenomenon at the time of the severe accident;
a second module configured to analyze an ex-vessel phenomenon at the time of the severe accident; and
a third module configured to analyze a behavior of fission products at the time of the severe accident using in-vessel thermal-hydraulic information and ex-vessel thermal-hydraulic information calculated in the first module and the second module, and
information is transferred between the first module, the second module, and the third module through the master module.

2. The severe accident analysis method of claim 1, wherein the accident simulation variable includes a set value of the accident simulation variable.

3. The severe accident analysis method of claim 2, wherein the validity determination step includes determining whether the accident simulation variable satisfies (1) an input allowable range, (2) a logical allowable range, and (3) a physical allowable range in the modular analysis code.

4. The severe accident analysis method of claim 1, wherein
the information includes first information required for the first module, the second module, and the third module, and second information generated by the first module, the second module, and the third module, and
the information is stored in the master module, and is provided from the master module upon a request from the first module, the second module, and the third module.

5. The severe accident analysis method of claim 1, wherein
the information includes thermal-hydraulic information, fission product information, and corium information,
the thermal-hydraulic information is transferred between the first module and the second module through the master module and calculated in association, and the thermal-hydraulic information calculated in association is transferred to the third module through the master module,
the fission product information is transferred from the third module to the master module, and
the corium information is transferred from the first module to the second module through the master module.

6. The severe accident analysis method of claim 1, wherein
the first module associates a thermal-hydraulic safety analysis code with a reactor core damage module,
the thermal-hydraulic safety analysis code includes a nuclear reactor coolant system model, and
the reactor core damage module includes a reactor core shape model, a reactor core heating model, a reactor core relocation model, and an in-lower-hemisphere reactor core corium behavior analysis model.

7. The severe accident analysis method of claim 1, wherein the second module includes a containment building thermal-hydraulic analysis model, a hydrogen combustion model, a steam explosion model, an HPME/DCH model, and a reactor core corium-concrete reaction model.

8. The severe accident analysis method of claim 1, wherein the third module includes a fission product release model, a fission product transport model, and a fission product removal model.
